# FASCICULE DE BREVET EUROPEEN

(11) **EP 1 176 468 B1**
(45) Date de publication et mention de la délivrance du brevet: **24.08.2011**
(21) Numéro de dépôt: 01401972.3
(22) Date de dépôt: 23.07.2001
(51) Int. Cl.: G03F 7/095, G03F 7/075

(54) **Bi-couche de résine pour photolithographie dans l'extrême ultraviolet (EUV) et procédé de photolithogravure en extrême ultraviolet (EUV)**
Zweischichten-Photolack für Extrem-Ultraviolett-Strahlung und Verfahren für Extrem-Ultraviolet Lithographie
Resin bilayer mask for extreme ultraviolet photolithography and extreme ultraviolet photolithographic method

(30) Priorité: 26.07.2000 FR 0009759
(43) Date de publication de la demande: 30.01.2002
(73) Titulaire: Fahrenheit Thermoscope LLC, Las Vegas, NV 89119 (US)
(72) Inventeur: Schiltz, André, 38330 Saint-Ismier (FR)
(74) Mandataire: Small, Gary James

(56) Documents cités:
- EP-A- 0 113 034
- US-A- 3 547 629
- US-A- 5 344 677
- PATENT ABSTRACTS OF JAPAN vol. 014, no. 094 (P-1010), 21 février 1990 (1990-02-21) & JP 01 302350 A (FUJITSU LTD), 6 décembre 1989 (1989-12-06)
- PATENT ABSTRACTS OF JAPAN vol. 007, no. 010 (P-168), 14 janvier 1983 (1983-01-14) & JP 57 168246 A (FUJITSU KK), 16 octobre 1982 (1982-10-16)

## Description

La présente invention concerne un procédé de photolithogravure d'un substrat semi conducteur ainsi qu'une couche de masquage utilisée pour ce procédé et qui contient des résines sensible aux longueurs d'onde de l'extrême ultra-violet (EUV). Ces résines sont destinées à la réalisation de masques résistant à la gravure par plasma et permettant la réalisation de structure à dimensions inférieures à 0,1 µm.

On appelle en général domaine de l'extrême ultra-violet, les longueurs d'onde inférieures à 100 nm et en particulier les longueurs d'onde voisines de 11 à 13 nanomètres.

Le domaine pour lesquels les longueurs d'onde sont comprises entre 300 et 100 nm est en général appelé domaine de l'ultraviolet profond. On rappelle également que le domaine de l'ultraviolet correspond à des longueurs d'onde comprises entre 700 et 300 nm.

Les longueurs d'onde couramment utilisées dans le domaine de la photolithogravure appartiennent au domaine ultra-violet profond (DUV) est sont en général de l'ordre de 193 à 248 nanomètres et permettent l'obtention de structure de dimensions critiques de 0,18 µm à 0,12 µm.

A ces longueurs d'onde, certaines résines présentent déjà un comportement de photo-ablation étant donné que l'énergie de la radiation est de l'ordre de 6,4 eV pour une longueur d'onde de 193 nm. Pour une longueur d'onde de 13 nm qui correspond à une énergie de 92,5 eV, on devrait observer la photo-ablation ou la sublimation partielle par dépolymérisation de nombreuses résines constituant les masques de photolithogravure.

Ces constatations conduisent à concevoir différemment la composition des matériaux constitutifs des masques de photolithogravure puisque l'addition de composés photosensibles ou de générateurs d'acide les rendant sensibles n'est plus nécessaire, les matériaux étant quasi-naturellement sensibles aux longueurs d'onde de 11 à 13 nm.

Les techniques actuelles de photolithogravure utilisent un laser excimère ArF à 193 nm (DUV) et permettent la fabrication de structures de dimension critiques de l'ordre de 0,1 µm par utilisation de masques à décalage de phase (MPD).

Déjà à cette longueur d'onde, des problèmes de transparence des masques commencent à apparaître et pour des longueurs d'onde plus courtes, d'autres limitations interviennent comme par exemple une absorption trop élevée des résines conventionnelles à amplification chimique, l'absence de transparence de la silice pour des longueurs d'onde inférieures à 160 nm qui impliquent l'utilisation de CaF₂ et l'obligation de travailler sous flux d'azote ou sous vide dès 172 nm.

Pour ces raisons et pour repousser les limites de la lithographie en UV profond sans avoir à recourir aux techniques MPD de nombreux essais utilisant l'extrême ultra-violet ont été réalisés en utilisant des longueurs d'onde voisines de 11 nm à 13 nm, d'autres explorant la lithographie par faisceaux de rayons X, la lithographie par faisceaux d'électrons ou la lithographie par faisceaux d'ions.

L'une des principales difficultés de la mise en oeuvre des techniques de lithographie au-dessous de 193 réside principalement dans la conception de l'outil lithographique. En particulier, on rencontre souvent des problèmes d'absorption de la lumière dans les optiques et l'unique solution est d'utiliser des optiques réflectives (miroirs et masque) plutôt que réfractives et de plus sous vide. Des "photorépéteurs" (équipements de répétition d'image puce par puce) fonctionnant en mode réflectif ont été ont été utilisés par exemple pour une longueur d'onde de 13,4 nm. D'autre part, des premiers essais montrent que les multi-couches de silicium et de molybdène offrent des taux de réflexion de l'ordre de 70 % pour une longueur d'onde de 13 nm (92,5 eV) visée en EUV. Ces multi-couches présentent une faible absorption et des indices de réfraction respectivement supérieur et inférieur à 1 dans la gamme 70-100 eV qui correspond à des longueurs d'onde de 18 à 12 nm. De tels masques sont réalisés par dépôt de palladium sur multi-couches de silicium et de molybdène.

En général, les sources utilisées pour produire un rayonnement EUV sont soit un synchrotron, soit un plasma généré par le tir d'un laser pulsé sur une cible métallique (Cu, Au et Sn) ou à l'aide de jets de gaz "clusters" de Xénon.

Pour ce qui est des résines photosensibles, compte tenu de l'absorption généralement élevée des polymères utilisés aux faibles longueurs d'onde, on devine que la sensibilité des résines photosensibles aux EUV sera élevée mais la profondeur de pénétration très faible, c'est pourquoi on préconise généralement l'emploi de techniques à imagerie de surface dite "TSI" (top surface imaging) telles que la silylation qui consiste en une diffusion de gaz réactif à base de disilane, les bi-couches constitués de résine organosiliciée et de résine planarisante, ou l'utilisation de couches sensibles très minces ou de couches de photo-ablation.

Comme cela vient d'être décrit, compte tenu de l'absorption élevée des résines connues aux faibles longueurs d'onde, la sensibilité des polymères aux radiations EUV est généralement élevée mais la profondeur de pénétration pourrait s'avérer trop faible pour autoriser l'emploi de couches de résine suffisamment épaisses pour servir de masque à la gravure et ceci quelle que soit la technique employée.

En particulier, pour des résines à imagerie de surface utilisant la technique de silylation qui fait intervenir la diffusion d'un gaz réactif à base de disilane dans les zones insolées, les principales limitations concernent la non-uniformité de silylation aussi bien locale que globale due à la diffusion du gaz et au gonflement des parties insolées et une sensibilité accrue de la résine à de nombreux paramètres comme la pression de travail ou la longueur d'onde utilisée.

Les résines à imagerie de surface faisant intervenir la technique des bi-couches constitués de résine organosiliciée et de résine planarisante semblent plus intéressantes que les techniques de silylation . En effet, les résines organosiliciées ont un fort potentiel car elles peuvent être constituées de molécules soit plus riches en carbone, soit plus riches en silice qui, après insolation aux EUV, adoptent un comportement positif ou négatif au développement. Ce comportement positif ou négatif s'obtient par un développement en solution acide ou basique des parties insolées plus riches en silice ou par un développement en solvant des parties non exposées. Des essais ont été effectués à 193 nm sur des polysiloxanes et polysilazanes pour la fabrication de structures à 0,1 et 0.2 nm qui montrent une sensibilité satisfaisante de 30 à 100 mJ/cm² à 193 nm. A 13.4 nm, l'énergie est bien supérieure (92.5 eV) et conduit même à l'excitation des électrons Si 2p et Si 2s. Il est cependant apparu que le facteur limitant restait l'absorption.

Cette voie, bien que prometteuse reste une technique d'imagerie de surface en raison de l'absorption de la lumière à la surface des couches et engendre des problèmes connexes de diffusion latérale et de résistance des motifs.

Une autre voie précédemment mentionnée consiste en l'étude de résines en mono-couche très minces en raison de l'absorption élevée des EUV dans les résines telles que des résines polysiloxanes comme celles évoquées ci-dessus ou telles que des esters méthacryliques.

En effet, de récentes observations ont été faites avec des résines à base d'esters méthacryliques du type HEMA(hydroxy-éthyl méthacrylate) sans amplification chimique qui montrent une sensibilité acceptable à 193 nm, aux faisceaux d'électrons et aux faisceaux de rayons X.

Cependant, ces résines ont une épaisseur nécessairement très mince et ne constituent pas un masque suffisamment résistant.

En ce qui concerne l'utilisation de couches de photoablation, des résines présentant ce comportement ont été essayées à 193 nm avec un relatif succès compte tenu de la faible énergie d'insolation (6.4 eV).

A la longueur d'onde de 13 nm l'énergie est bien supérieure (92.5 eV) et permet une photoablation plus aisée de certains polymères ou une sublimation par dépolymérisation de polymères intrinsèquement instables.

Des essais ont été effectués avec des polymères intrinsèquement instables du type polyphtalaldéhyde, polymère synthétisé en dessous de sa température plancher, c'est à dire à une température au-dessus de laquelle l'équilibre des réactions de polymérisation et de dépolymérisation se déplacerait vers la dépolymérisation, et stabilisé par greffage d'une molécule stable en bout de chaîne.

Le problème principal de l'utilisation de couches de photo-ablation en mono-couche est qu'elles ne résistent pas à la gravure plasma à cause même de leur capacité à la photo-ablation et ne constituent pas de couches de masquage fonctionnelles.

Le but de invention est donc de palier aux problèmes soulevés par l'état de la technique et de permettre l'exécution d'une photolithogravure sous des radiations de l'extrême ultraviolet.

Selon un aspect de l'invention, la résolution des problèmes de l'état de la technique est obtenue par la fourniture d'une couche de masquage pour la gravure de substrat semi-conducteur selon la revendication 1 sur laquelle le motif à graver est transférable par photolithographie aux longueurs d'onde comprises entre 10 et 100 nm de l'extrême ultraviolet et qui est résistante à la gravure par plasma.

Cette couche de masquage pour la gravure de substrat semi-conducteur comprend une structure bi-couche comprenant une couche supérieure d'un matériau sensible aux longueurs d'onde comprises entre 10 et 100 nm de l'extrême ultraviolet et résistant aux longueurs d'onde comprises entre 300 et 100 nm de l'ultraviolet profond et/ou aux longueurs d'onde comprises entre 700 et 300 nm de l'ultraviolet et une couche inférieure d'un matériau résistant aux longueurs d'onde comprises entre 10 et 100 nm de l'extrême ultraviolet et à la gravure par plasma une fois le développement de ladite résine réalisé et sensible aux longueurs d'onde comprises entre 300 et 100 nm de l'ultraviolet profond et/ou aux longueurs d'onde comprises entre 700 et 300 nm de l'ultraviolet.

Ainsi selon l'invention, la couche supérieure est une résine non résistante aux radiations de l'extrême ultraviolet au sein de laquelle l'image du masque lithographique est transférée par un processus physique que l'on appelle photoablation et qui ne nécessite pas d'étape de développement, et la couche inférieure est une résine résistante aux radiations de l'extrême ultraviolet qui servira de couche de masquage résistant à la gravure plasma une fois le développement de ladite résine réalisé.

La couche supérieure ainsi définie sert de masque auto-porté lors du transfert d'image par insolation pleine plaque dans la couche inférieure.

Un des avantages d'un assemblage de matériaux définissant la structure bi-couche selon l'invention est qu'il nécessite une étape de photolithographie EUV et une insolation DUV pleine plaque mais qu'il ne nécessite qu'une seule étape de développement en phase liquide usuelle ou en phase sèche par plasma.

En particulier, un tel assemblage, comprenant une couche supérieure de photoablation et une couche inférieure développable à sec, permet d'économiser une piste d'étalement et garantit une définition optimale de motifs lithographiques en dessous de 0,1 µm.

La couche supérieure de l'assemblage bi-couche selon l'invention a les propriétés suivantes :
elle n'est pas nécessairement résistante à la gravure plasma elle est sensible aux EUV et se décompose par photo-ablation et ne nécessite donc pas d'étape de développement supplémentaire
elle résiste aux DUV et UV, permettant ainsi la définition des motifs par insolation pleine plaque dans la couche inférieure résistante aux radiations de l'extrême ultraviolet.

Selon l'invention, le matériau pour la couche supérieure de l'assemblage bi-couche selon l'invention est choisi parmi une résine à base de nitrocellulose et/ou une résine à base de polyphtalaldéhyde.

La couche inférieure de l'assemblage bi-couche selon l'invention a les propriétés suivantes:
après développement, elle doit résister à la gravure plasma de la couche à graver et en particulier, pour la gravure de grilles en silicium poly-cristallin, elle doit résister au plasmas chlorés, bromés et fluorés),
elle est sensible aux DUV et/ou UV, permettant ainsi la définition des motifs par insolation pleine plaque.

En particulier, selon un mode de réalisation de l'invention, la couche inférieure comprend un matériau susceptible de se transformer en pseudo-silice.

Selon un mode particulier de réalisation d'une structure bi-couche selon l'invention, la transformation du matériau compris dans ladite couche inférieure en pseudo-silice est obtenue au moyen d'un traitement plasma à base d'oxygène.

Selon l'invention, ladite couche inférieure comprend un matériau organosilicié choisi parmi les polysiloxanes et/ou les polysilazanes.

De préférence également, ledit matériau organosilicié est choisi parmi le polyphénylmethylsilsesquioxane ou le perhydrosilazane.

Dans un mode particulier de réalisation des couches de masquage selon l'invention, ladite couche inférieure est obtenue par dépôt d'un plasma de polymethylsilane.

L'invention concerne également l'utilisation d'une couche de masquage sleon la revendication 9, comprenant une couche de photo-ablation sensible aux longueurs d'onde comprises entre 10 et 100 nm de l'extrême ultraviolet et résistant aux longueurs d'onde comprises entre 300 et 100 nm de l'ultraviolet profond et/ou aux longueurs d'onde comprises entre 700 et 300 nm de l'ultraviolet couplée à une couche de résine polymère résistante aux longueurs d'onde comprises entre 10 et 100 nm de l'extrême ultraviolet et à la gravure par plasma une fois le développement de ladite résine réalisé et sensible aux longueurs d'onde comprises entre 300 et 100 nm de l'ultraviolet profond et/ou aux longueurs d'onde comprises entre 700 et 300 nm de l'ultraviolet pour la gravure de substrat semi-conducteur.

L'utilisation de masque de photolithographie conforme à l'invention permet la réalisation de motifs de dimensions inférieures à 0,1 µm. L'image du masque lithographique est réalisée directement dans la couche supérieure par un processus physique de photo-ablation sans perte de cote du fait que les effets de diffusion ou de dissolution classiques du développement humide sont supprimés.

Ladite couche de photoablation ou couche supérieure comprend une résine à base de nitrocellulose et/ou une résine à base de polyphtalaldéhyde.

Selon une autre utilisation, ladite couche de résine polymère comprend un matériau susceptible de se transformer en pseudo-silice.

En particulier, la transformation du matériau compris dans ladite couche polymère en pseudo-silice est obtenue au moyen d'un traitement par un plasma à base d'oxygène.

Selon l'invention, ladite couche inférieure de résine polymère comprend un matériau organosilicié, ledit matériau organosilicié est choisi parmi les polysiloxanes et/ou les polysilazanes.

De préférence également, ledit matériau organosilicié est choisi parmi le polyphénylmethylsilsesquioxane ou le perhydrosilazane.

Pour une utilisation particulière selon l'invention, ladite couche de résine polymère est obtenue par dépôt d'un plasma de polymethylsilane.

L'invention concerne également un procédé de photolitogravure selon la revendication 6 impliquant l'utilisation de masque conforme à l'invention et en particulier un procédé de photolithogravure d'un substrat semi-conducteur en ultraviolet comprenant une étape d'insolation en ultraviolet d'une couche de résine polymère recouvrant un substrat étant une couche destinée à être gravée disposée sur une couche de support, une étape de développement de ladite couche de résine polymère après insolation et une étape de gravure de ladite couche destinée à être gravée selon le motif du masque ainsi formé dans lequel on insole une première couche de résine polymère résistante aux longueurs d'onde comprises entre 300 et 100 nm de l'ultraviolet profond et/ou aux longueurs d'onde comprises entre 700 et 300 nm de l'ultraviolet par les longueurs d'onde comprises entre 10 et 100 nm de l'extrême ultraviolet, puis on insole une deuxième couche de résine polymère résistant aux longueurs d'onde comprises entre 10 et 100 nm de l'extrême ultraviolet et à la gravure par plasma une fois le développement de ladite résine réalisé, par les longueurs d'onde comprises entre 300 et 100 nm de l'ultraviolet profond avant de procéder au développement du motif du masque ainsi insolé et à la gravure de ladite couche destinée à être gravée.

Selon l'invention, on choisira ladite couche supérieure de résine polymère comprenant une résine à base de nitrocellulose et/ou une résine à base de polyphtalaldéhyde.

En particulier, selon un mode de réalisation de l'invention, ladite deuxième couche de résine polymère comprend un matériau susceptible de se transformer en pseudo-silice.

Selon un mode particulier de réalisation d'une structure bi-couche selon l'invention, la transformation du matériau compris dans ladite deuxième couche polymère en pseudo-silice est obtenue au moyen d'un traitement par un plasma à base d'oxygène.

Selon l'invention, ladite couche inférieure de résine polymère comprend un matériau organosilicié, ledit matériau organosilicié est choisi parmi les polysiloxanes et/ou les polysilazanes.

De préférence également, ledit matériau organosilicié est choisi parmi le polyphénylmethylsilsesquioxane ou le perhydrosilazane.

Dans un mode particulier de mise en oeuvre du procédé selon l'invention, ladite deuxième couche de résine polymère est obtenue par dépôt d'un plasma de polymethylsilane.

D'autres avantages de l'invention apparaîtront à la lecture de la suite de la description présentant de manière figurative et non-limitative une mise en oeuvre d'un procédé selon l'invention utilisant un masque de gravure bi-couche selon l'invention.

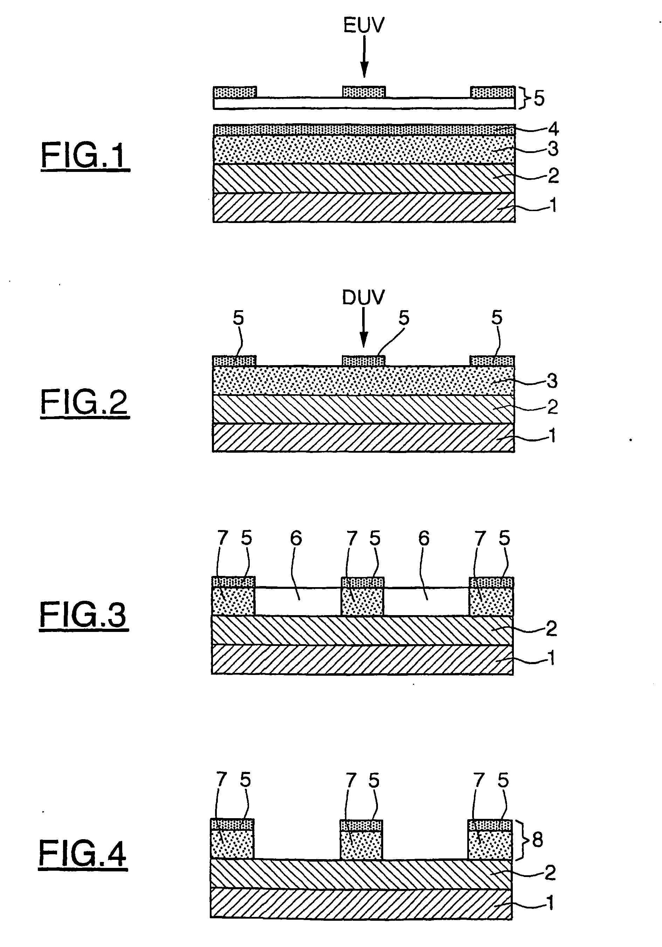

Les figures 1 à 7 présentent des vues en coupe d'un dispositif comprenant une couche de masquage selon l'invention aux différentes étapes de la réalisation du procédé selon l'invention.

La figure 1 présente un assemblage comprenant une couche support 1 sur une surface de laquelle repose une couche 2 d'un substrat destiné à être gravé. Sur cet assemblage est disposé une première couche 3 de résine polymère résistant aux longueurs d'onde comprises entre 10 et 100 nm de l'extrême ultraviolet et à la gravure par plasma une fois le développement de ladite résine réalisé et sensible aux longueurs d'onde comprises entre 300 et 100 nm de l'ultraviolet profond. Enfin une deuxième couche 4 de résine polymère résistante aux longueurs d'onde comprises entre 300 et 100 nm de l'ultraviolet profond et/ou aux longueurs d'onde comprises entre 700 et 300 nm de l'ultraviolet et sensible aux longueurs d'onde comprises entre 10 et 100 nm de l'extrême ultraviolet complète cet assemblage de départ. Un masque 5 portant le motif à graver sur la couche 2 est alors utilisé.

Idéalement, on choisira, comme matériau constitutif du support 1, un matériau contenant du silicium, par exemple du silicium pur mono- ou poly- cristallin, ou tout autre matériau communément utilisé dans la réalisation de circuits intégrés.

En ce qui concerne la couche 2 du substrat destiné à être gravé, on choisira également un matériau contenant du silicium et de préférence un matériau de composition différente de celle du support 1 comme par exemple un alliage silicium/germanium du type Si₁₋ₓGeₓ (0<x<1) ou du type Si_{1-x-y}GeₓC_{y} (0<x<0.95 et 0<y<0.95) qui seront sélectivement éliminables par rapport au matériau du support 1, par exemple, au moyen d'une chimie oxydante humide, par exemple avec une solution 40 ml HNO₃ 70% + 20 ml H₂O₂ + 5 ml HF 0,5%, soit au moyen d'une attaque par un plasma isotrope.

La couche supérieure 4 choisie parmi des matériaux comprenant une résine à base de nitrocellulose et/ou une résine à base de polyphtalaldéhyde. En effet, ces matériaux sont photo-ablatables en EUV mais présentent une résistance de l'ordre de 2000 à 3000 mJ/cm² à 193 nm. Par exemple, une résine à base de nitrocellulose présente une sensibilité de 140 mJ/cm² en EUV et une sensibilité de 3000 mJ/cm² à 193 nm. Ces matériaux peuvent être indifféremment résistant ou non à la gravure par plasma.

La couche inférieure 3 comprend un matériau susceptible de se transformer en pseudo-silice, par exemple au moyen d'un traitement par un plasma à base d'oxygène. Ce matériau est un matériau organosilicié, choisi parmi les polysiloxanes et/ou les polysilazanes.

Le matériau organosilicié constitutif de la couche inférieure 3 peut également être choisi parmi le polyphénylmethylsilsesquioxane, le perhydrosilazane ou encore être obtenu par dépôt d'un plasma de polymethylsilane. Ces matériaux présentent une sensibilité inférieure à 100 mJ/cm² à 193 nm. Par exemple, le polyphénylmethylsilsesquioxane et le perhydrosilazane présentent des sensibilités respectives de 100 et 40 mJ/cm² à 193 nm.

Les matériaux constitutifs de la couche inférieure 3 sont toutefois choisis de manière qu'ils soient résistant à la gravure par plasma une fois le développement de ladite résine réalisé aux longueurs d'onde comprises entre 300 et 100 nm de l'ultraviolet profond.

Cet assemblage est alors soumis à une insolation en extrême ultraviolet, par exemple à 13,4 nm. La deuxième couche subit alors une photoablation dans les zone non protégées par le masque 5.

On obtient alors l'assemblage illustré à la figure 2 qui montre des îlots résiduels 5 de la couche 4 entourés par des zones vides provenant de la photoablation de la couche 4.

On soumet alors l'assemblage à une insolation en ultraviolet profond, par exemple à 193 nm.

On obtient alors l'assemblage illustré à la figure 3 qui montre, sous les îlots résiduels 5 de la couche 4 entourés par des zones vides provenant de la photoablation de la couche 4, des îlots résiduels 7 de la couche 3 qui n'ont pas été attaqués par les radiations de l'ultraviolet profond et des zones 6, non protégées, qui ont subi l'attaque des radiations de l'ultraviolet profond.

A ce stade, deux voies de développement positive ou négative sont réalisables. Chacune de ces voies est illustrée respectivement par les figures 4 à 5 et 6 à 7.

Dans un premier mode de développement, dit positif, on soumet l'assemblage tel qu'illustré à la figure 3 à un développement humide permettent d'éliminer les zones 6 ayant été irradiées par l'ultraviolet profond.

On obtient alors l'assemblage illustré à la figure 4 qui présente une couche support 1 sur une surface de laquelle repose une couche 2 d'un substrat destiné à être graver. Sur cette couche 2 reposent des empilements 8 constitués des îlots résiduels 7 de la couche 3 résistant à la gravure par plasma et des îlots résiduels 5 de la couche 4.

On grave alors l'assemblage ainsi réalisé de manière à éliminer les parties de la couche 2 laissées libres et non protégées par les empilements 8.

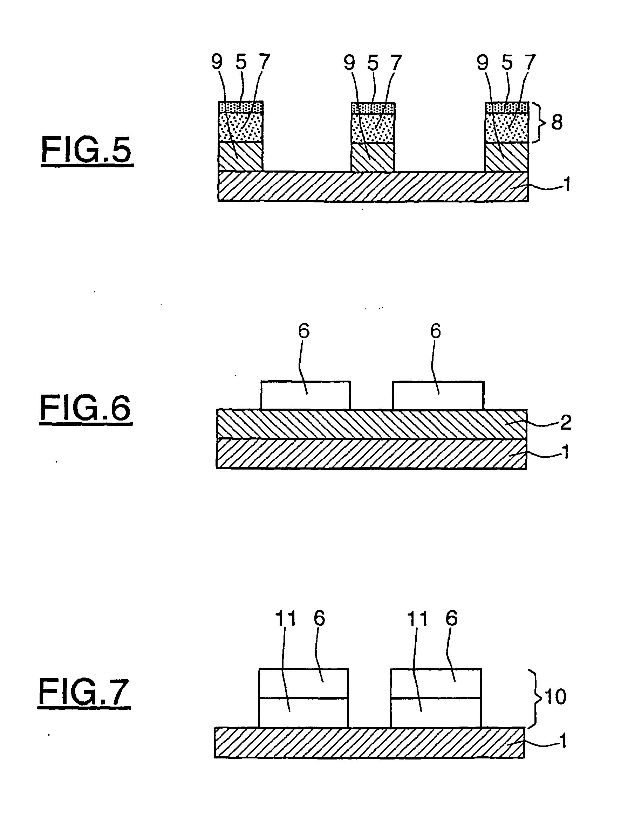

On obtient alors l'assemblage illustré à la figure 5 qui présente des îlots résiduels 9 de la couche 2 correspondant aux zones non protégées par les empilements 8 et représentant le motif du masque 5 de la figure 1. La présence des îlots résiduels 5 dépendra de la résistance du matériau utilisé pour élaborer la première couche 3 de résine polymère.

Dans un deuxième mode de développement, dit négatif, on soumet l'assemblage tel qu'illustré à la figure 3 à un développement à sec, par exemple à un plasma à base d'oxygène.

On obtient alors l'assemblage illustré à la figure 6 qui présente les zones 6 qui ont subi l'attaque des radiations de l'ultraviolet profond et présentent une résistance à la gravure par plasma, reposant sur une couche 2 d'un substrat destiné à être gravé reposant elle-même sur une surface d'une couche support 1. Les zones 6 sont présentes du fait de leur résistance, une fois la couche 3 insolée, au plasma à base d'oxygène. De préférence, dans ce mode de mise en oeuvre, on choisira pour les couches 3 et 4 un matériau ne présentant pas de résistance intrinsèque à un plasma à base d'oxygène.

On grave alors l'assemblage ainsi réalisé de manière à éliminer les parties de la couche 2 laissées libres et non protégées par les zones 6 de la couche 3 de la même manière que lors du développement positif.

On obtient alors l'assemblage illustré à la figure 7 qui présente des empilements 10 constitués des zones 6 de la couche 3 et des îlots résiduels 11 de la couche 2 protégés par les zones 6 de la couche 3. On obtient alors le négatif du motif du masque 5 de la figure 1.

## Revendications

1. Couche de masquage pour la gravure d'un substrat semi-conducteur **caractérisée en ce que** le motif à graver est transférable à ladite couche de masquage par photolithographie aux longueurs d'onde comprises entre 10 et 100 nm de l'extrême ultraviolet et que la couche de masquage (4, 3) est résistante à la gravure par plasma, et **en ce qu'**elle comprend une structure bi-couche comprenant une couche supérieure (4) de photo-ablation d'un matériau sensible aux longueurs d'onde comprises entre 10 et 100 nm de l'extrême ultraviolet et résistant aux longueurs d'onde comprises entre 300 et 100 nm de l'ultraviolet profond et/ou aux longueurs d'onde comprises entre 700 et 300 nm de l'ultraviolet et une couche inférieure (3) d'un matériau résistant aux longueurs d'onde comprises entre 10 et 100 nm de l'extrême ultraviolet et (à la gravure par plasma une fois le développement de la couche de masquage réalisé) et sensible aux longueurs d'onde comprises entre 300 et 100 nm de l'ultraviolet profond et/ou aux longueurs d'onde comprises entre 700 et 300 nm de l'ultraviolet,
où ladite couche supérieure comprend un matériau choisi parmi les résines à base de nitrocellulose et/ou les résines à base polyphtalaldéhyde et ladite couche inférieure comprend un matériau organosilicié susceptible de se transformer en pseudo silice choisi parmi les polysiloxanes et/ou les polysilazanes.

2. Couche de masquage pour la gravure de substrat semi-conducteurs selon la revendication 1, **caractérisée en ce que** la transformation du matériau organosilicié compris dans ladite couche inférieure est obtenue au moyen d'un traitement par un plasma à base d'oxygène.

3. Couche de masquage pour la gravure de substrat semi-conducteurs selon l'une quelconque des revendications 1 à 2, **caractérisée en ce que** le matériau organosilicié est choisi parmi le polyphénylmethylsilsesquioxane ou le perhydrosilazane.

4. Couche de masquage pour la gravure de substrat semi-conducteurs selon l'une quelconque des revendications 1 à 3, **caractérisée en ce que** ladite couche inférieure est obtenue par dépôt d'un plasma de polymethylsilane.

5. Procédé de photolithogravure d'un substrat semi-conducteur en ultraviolet comprenant:
une étape d'insolation en ultraviolet d'une couche de masquage selon la revendication 1 recouvrant un substrat destiné à être gravé disposé sur une couche de support,
une étape de développement de la couche de masquage (4, 3) après insolation et
une étape de gravure du dite substrat à être gravé selon le motif du masque ainsi formé
ladite couche de masquage comprenant une structure bi-couche comprenant une couche supérieure (4) et une couche inférieure (3),
**caractérisé en ce que** l'étage d'insolation consiste à insoler ladite couche supérieure de photo-ablation résistante aux longueurs d'onde comprises entre 300 et 100 nm de l'ultraviolet profond et/ou aux longueurs d'onde comprises entre 700 et 300 nm de l'ultraviolet avec une longueur d'onde comprises entre 10 et 100 nm de l'extrême ultraviolet, puis a insoler ladite couche inférieure résistante aux longueurs d'onde comprises entre 10 et 100 nm de l'extrême ultraviolet et à la gravure par plasma une fois le développement de la couche de masquage réalisé, avec une longueur d'onde comprise entre 300 et 100 nm de l'ultraviolet profond,
ladite couche supérieure comprenant un matériau choisi parmi les résines à base de nitrocellulose et/ou les résines à base polyphtalaldéhyde et ladite couche inférieure comprenant un matériau organosilicié choisi parmi les polysiloxanes et/ou les polysilazanes.

6. Procédé selon la revendication 5, **caractérisé en ce que** ladite couche supérieure comprend un matériau défini à la revendication 2.

7. Procédé selon l'une quelconque des revendications 5 ou 6, **caractérisé en ce que** ladite couche inférieure comprend un matériau défini à l'une quelconque des revendications 2 à 4.

8. Utilisation d'une couche de masquage pour la gravure de substrat semi-conducteurs,
la couche de masquage (4, 3) comprenant une structure bi-couche comprenant une couche supérieure (4) et une couche inférieure (3),
la couche supérieure de photo-ablation étant sensible aux longueurs d'onde comprises entre 10 et 100 nm de l'extrême ultraviolet et résistant aux longueurs d'onde comprises entre 300 et 100 nm de l'ultraviolet profond et/ou aux longueurs d'onde comprises entre 700 et 300 nm de l'ultraviolet
la couche inférieure étant résistante aux longueurs d'onde comprises entre 10 et 100 nm de l'extrême ultraviolet et à la gravure par plasma une fois le développement de la couche de masquage réalisé et sensible aux longueurs d'onde comprises entre 300 et 100 nm de l'ultraviolet profond et/ou aux longueurs d'onde comprises entre 700 et 300 nm de l'ultraviolet
ladite couche supérieure comprenant un matériau choisi parmi les résines à base de nitrocellulose et/ou les résines à base polyphtalaldéhyde et ladite couche inférieure comprenant un matériau organosilicié choisi parmi les polysiloxanes et/ou les polysilazanes.

9. Utilisation selon la revendication 8, **caractérisée en ce que** ladite couche inférieure comprend un matériau défini à l'une quelconque des revendications 2 à 4.

## Claims

1. Masking layer, for the etching of semiconductor substrates, **characterized in that** the pattern to be etched is transferable to said masking layer by photolithography at wavelengths between 10 and 100 nm in the extreme ultraviolet and that the masking layer (4, 3) is resistant to plasma etching, and **in that** it comprises a bilayer structure comprising a photoablation top layer (4) of a material sensitive to wavelengths between 10 and 100 nm in the extreme ultraviolet and resistant to wavelengths between 300 and 100 nm in the deep ultraviolet and/or to wavelengths between 700 and 300 nm in the ultraviolet and a bottom layer (3) of a material resistant to wavelengths between 10 and 100 nm in the extreme ultraviolet (and to plasma etching once the masking layer has been developed) and sensitive to wavelengths between 300 and 100 nm in the deep ultraviolet and/or to wavelengths between 700 and 300 nm in the ultraviolet,
wherein said top layer comprises a material chosen from nitrocellulose-based resists and/or polyphthalaldehyde-based resists and said bottom layer comprises an organosilicon material that can be converted into a pseudo-silica chosen from the polysiloxanes and/or the polysilazanes.

2. Masking layer, for the etching of semiconductor substrates, according to Claim 1, **characterized in that** the organosilicon material of said bottom layer is converted by means of treatment with an oxygen-based plasma.

3. Masking layer, for the etching of semiconductor substrates, according to either one of Claims 1 and 2, **characterized in that** the organosilicon material is chosen from polyphenylmethylsilsesquioxane and perhydrosilazane.

4. Masking layer, for the etching of semiconductor substrates, according to any one of Claims 1 to 3, **characterized in that** said bottom layer is obtained by plasma deposition from a polymethylsilane plasma.

5. Ultraviolet photolithographic etching process for a semiconductor substrate comprising:
a step of exposing a masking layer according to Claim 1 to ultraviolet radiation, said layer covering a substrate intended to be etched, placed on a supporting layer;
a step of developing the masking layer (4, 3) after exposure; and
a step of etching said substrate to be etched with the pattern of the mask thus formed,
said masking layer comprising a bilayer structure comprising a top layer (4) and a bottom layer (3),
**characterized in that** the exposure stage consists in exposing said photoablation top layer resistant to wavelengths between 300 and 100 nm in the deep ultraviolet and/or to wavelengths between 700 and 300 nm in the ultraviolet to radiation with a wavelength between 10 and 100 nm in the extreme ultraviolet, then exposing said bottom layer resistant to wavelengths between 10 and 100 nm in the extreme ultraviolet and to plasma etching once the masking layer has been developed to radiation with a wavelength between 300 and 100 nm in the deep ultraviolet,
said top layer comprising a material chosen from nitrocellulose-based resists and/or polyphthalaldehyde-based resists and said bottom layer comprising an organosilicon material chosen from the polysiloxanes and/or the polysilazanes.

6. Process according to Claim 5, **characterized in that** said top layer comprises a material as defined in Claim 2.

7. Process according to either of Claims 5 and 6, **characterized in that** said bottom layer comprises a material as defined in any one of Claims 2 to 4.

8. Use of a masking layer for the etching of semiconductor substrates,
the masking layer (4, 3) comprising a bilayer structure comprising a top layer (4) and a bottom layer (3),
the photoablation top layer being sensitive to wavelengths between 10 and 100 nm in the extreme ultraviolet and resistant to wavelengths between 300 and 100 nm in the deep ultraviolet and/or to wavelengths between 700 and 300 nm in the ultraviolet,
the bottom layer being resistant to wavelengths between 10 and 100 nm in the extreme ultraviolet and to plasma etching once the masking layer has been developed and sensitive to wavelengths between 300 and 100 nm in the deep ultraviolet and/or to wavelengths between 700 and 300 nm in the ultraviolet,
said top layer comprising a material chosen from nitrocellulose-based resists and/or polyphthalaldehyde-based resists and said bottom layer comprising an organosilicon material chosen from the polysiloxanes and/or the polysilazanes.

9. Use according to Claim 8, **characterized in that** said bottom layer comprises a material as defined in any one of Claims 2 to 4.

## Patentansprüche

1. Maskierungsschicht zum Ätzen eines Halbleitersubstrats, **dadurch gekennzeichnet, dass** das zu ätzende Muster auf die Maskierungsschicht durch Photolithographie bei Wellenlängen im Bereich von 10 bis 100 nm am Ultraviolettende übertragbar ist und dass die Maskierungsschicht (4, 3) gegenüber dem Ätzen durch Plasma beständig und dass sie eine Doppelschichtstruktur umfasst, die eine obere Schicht (4) für die Photoablation eines Materials, das für Wellenlängen im Bereich von 10 bis 100 nm am Ultraviolettende empfindlich ist und das bei Wellenlängen im Bereich von 300 bis 100 nm im tiefen Ultraviolett und/oder bei Wellenlängen im Bereich von 700 bis 300 nm im Ultraviolett beständig ist, und eine untere Schicht (3) aus einem Material, die bei Wellenlängen im Bereich von 10 bis 100 nm am Ultraviolettende beständig ist und (bei einer Plasmaätzung, sobald die Entwicklung der Maskierungsschicht erfolgt ist) für Wellenlängen im Bereich von 300 bis 100 nm im tiefen Ultraviolett und/oder für Wellenlängen im Bereich von 700 bis 300 nm im Ultraviolett empfindlich ist, enthält,
wobei die obere Schicht ein Material enthält, das aus Harzen auf Nitrozellulosebasis und/oder aus Harzen auf Polyphthalaldehyd gewählt ist, und die untere Schicht ein organosiliciertes Material enthält, das sich in Pseudosiliciumoxid umwandeln kann, das aus Polysiloxanen und/oder Polysilazanen gewählt ist.

2. Maskierungsschicht zum Ätzen eines Halbleitersubstrats nach Anspruch 1, **dadurch gekennzeichnet, dass** die Umwandlung des organosilicierten Materials, das in der unteren Schicht enthalten ist, mittels einer Behandlung durch ein Plasma auf Sauerstoffbasis erhalten wird.

3. Maskierungsschicht zum Ätzen eines Halbleitersubstrats nach einem der Ansprüche 1 bis 2, **dadurch gekennzeichnet, dass** das organosilicierte Material aus Polyphenylmethylsilsesquioxan und Perhydrosilazan gewählt ist.

4. Maskierungsschicht zum Ätzen eines Halbleitersubstrats nach einem der Ansprüche 1 bis 3, **dadurch gekennzeichnet, dass** die untere Schicht durch Ablagerung eines Polymethylsilan-Plasmas erhalten wird.

5. Verfahren zum Photolithoätzen eines Halbleitersubstrats im Ultraviolett, das umfasst:
einen Schritt des Bestrahlens mit Ultraviolettlicht einer Maskierungsschicht nach Anspruch 1, die ein Substrat abdeckt, das geätzt werden soll und auf einer Trägerschicht angeordnet ist,
einen Schritt des Entwickelns der Maskierungsschicht (4, 3) nach dem Bestrahlen und
einen Schritt des Ätzens des Substrats, das geätzt werden soll, in einem auf diese Weise gebildeten Maskierungsmuster,
wobei die Maskierungsschicht eine Doppelschichtstruktur aufweist, die eine obere Schicht (4) und eine untere Schicht (3) enthält,
**dadurch gekennzeichnet, dass** der Bestrahlungsschritt darin besteht, die obere Photoablationsschicht, die bei Wellenlängen im Bereich von 300 bis 100 nm im tiefen Ultraviolett und/oder bei Wellenlängen im Bereich von 700 bis 300 nm im Ultraviolett beständig ist, mit einer Wellenlänge im Bereich von 10 bis 100 nm am Ultraviolettende zu bestrahlen und dann die untere Schicht, die bei Wellenlängen im Bereich von 10 bis 100 nm am Ultraviolettende und gegenüber dem Ätzen durch Plasma, sobald die Entwicklung der Maskierungsschicht erfolgt ist, beständig ist, mit einer Wellenlänge im Bereich von 300 bis 100 nm im tiefen Ultraviolett zu bestrahlen,
wobei die obere Schicht ein Material enthält, das aus Harzen auf Nitrozellulose-Basis und/oder aus Harzen auf Polyphthalaldehyd-Basis gewählt ist, und die untere Schicht ein organosiliciertes Material enthält, das aus Polysiloxanen und/oder Polysilazanen gewählt ist.

6. Verfahren nach Anspruch 5, **dadurch gekennzeichnet, dass** die obere Schicht ein Material enthält, das in Anspruch 2 definiert ist.

7. Verfahren nach einem der Ansprüche 5 oder 6, **dadurch gekennzeichnet, dass** die untere Schicht ein Material enthält, das in einem der Ansprüche 2 bis 4 definiert ist.

8. Verwendung einer Maskierungsschicht zum Ätzen eines Halbleitersubstrats,
wobei die Maskierungsschicht (4, 3) eine Doppelschichtstruktur umfasst, die eine obere Schicht (4) und eine untere Schicht (3) enthält,
wobei die obere Photoablationsschicht für Wellenlängen im Bereich von 10 bis 100 nm am Ultraviolettende empfindlich ist und bei Wellenlängen im Bereich von 300 bis 100 nm im tiefen Ultraviolett und/oder bei Wellenlängen im Bereich von 700 bis 300 nm im Ultraviolett beständig ist,
wobei die untere Schicht bei Wellenlängen im Bereich von 10 bis 100 nm am Ultraviolettende und gegenüber dem Ätzen durch Plasma, sobald die Entwicklung der Maskierungsschicht erfolgt ist, beständig ist und für Wellenlängen im Bereich von 300 bis 100 nm im tiefen Ultraviolett und/oder für Wellenlängen im Bereich von 700 bis 300 nm im Ultraviolett empfindlich ist,
wobei die obere Schicht ein Material enthält, das aus Harzen auf Nitrozellulosebasis und/oder aus Harzen auf Polyphthalaldehyd-Basis gewählt ist, und die untere Schicht ein organosiliciertes Material enthält, das aus Polysiloxanen und/oder Polysilazanen gewählt ist.

9. Verwendung nach Anspruch 8, **dadurch gekennzeichnet, dass** die untere Schicht ein Material enthält, das in einem der Ansprüche 2 bis 4 definiert ist.
